Europäisches Patentamt

European Patent Office

Office européen des brevets

(11) Publication number: **0 252 248**
A2

(12) **EUROPEAN PATENT APPLICATION**

(21) Application number: **87106940.7**

(22) Date of filing: **13.05.87**

(51) Int. Cl.³: **H 01 L 41/18**

(30) Priority: **13.05.86 JP 107660/86**
**11.09.86 JP 212647/86**

(43) Date of publication of application:
**13.01.88 Bulletin 88/2**

(84) Designated Contracting States:
**AT BE CH DE ES FR GB GR IT LI LU NL SE**

(71) Applicant: **TOYO SODA MANUFACTURING CO., LTD.**
**No. 4560, Ooaza Tonda Shinnanyo-shi**
**Yamaguchi-ken(JP)**

(72) Inventor: **Kasai, Kiyoshi**
**No. 1775, Okada**
**Atsugi-shi Kanagawa(JP)**

(72) Inventor: **Sakai, Naomichi**
**No. 423-18, Kosono**
**Ayase-shi Kanagawa(JP)**

(72) Inventor: **Oikawa, Tomoyuki**
**No. 15-1, Hachimandai 2-chome**
**Isehara-shi Kanagawa(JP)**

(72) Inventor: **Uchino, Kenji**
**No. 4200-2-103, Totsukacho Totsuka-ku**
**Yokohama-shi Kanagawa(JP)**

(72) Inventor: **Tsukidate, Takaaki**
**No. 344-275, Hodokubo**
**Hino-shi Tokyo(JP)**

(74) Representative: **Vossius & Partner**
**Siebertstrasse 4 P.O. Box 86 07 67**
**D-8000 München 86(DE)**

(54) **Actuator.**

(57) An actuator of the present invention is composed of a monomorph-type piezoelectric ceramic. The monomorph-type piezoelectric ceramic is a $BaTiO_3$-based ceramic that has a dielectric loss of at least 5% at 1kHz and whose dielectric loss at 100kHz drops by at least 30% of the value at 1 kHz that in a single layer deflects without preliminary poling.

FIG. 2

VOSSIUS+PARTNER
PATENTANWÄLTE
8000 MÜNCHEN 86
SIEBERTSTRASSE 4
TELEFON 474075

0252248

Our ref .: W 517 EP
Case: T04-45424M/YO
Toyo Soda Manufacturing Co., Ltd.
Yamaguchi, Japan

13. Mai 1987

## ACTUATOR

The present invention relates to an actuator that is useful as a drive source for positioning with precision machine, for controlling flow rates with valves, for operating fans associated with such valves, or for controlling the length of the optical path of an optical device, or as transducers in piezoelectric speakers and ultrasonic transducers. The term "actuator", as used herein, includes not only elements used to displace the objects with which they are in contact but also elements that move themselves without causing other objects to be displaced.

## BACKGROUND OF THE INVENTION

Two types of elements have previously been known that make use of the deflection properties of piezoelectric ceramics; one is of the _unimorph_ type in which a single thin layer of a poled piezoelectric ceramic material is adhered to a fixed electrode plate (shim); the other is of the _bimorph_ type in which a thin layer of a poled ceramic is adhered to both sides of the shim.

These devices suffer from two major problems: if a high instantaneous negative voltage

- 1 -

is applied or if negative voltages are applied for a prolonged period, either the piezoelectric ceramic material is depolarized or the adhesive between the ceramic material and the electrode material deteriorates such as to cause them to separate from each other. As a result, the life of these elements that are used as actuators is inevitably short.

The present inventors have discovered a piezoelectric ceramic material that can be described as a monomorph-type ceramic in that a single layer of this material is capable of deflecting without preliminary poling. The problems associated with the prior art can be effectively solved to a significant extent by using such monomorph-type piezoelectric ceramics as actuators.

## BRIEF DESCRIPTION OF THE DRAWINGS

FIGURE 1 is a schematic diagram of the actuators in plate form prepared in Examples 1 to 23 and Comparative Examples 1 to 7 and shows the longitudinal and transversal dimensions (in mm) of the actuator; points A, B and C are the points of deflection measurement and area D the area in which the actuator was fixed;

-2-

FIGURES 2 to 5 illustrate graphically the data measurements conducted in Example 24; Figure 2 is a graph showing the relationship between the electric field and the displacement of an actuator in a bipolar drive.

FIGURE 3 is a graph showing the electric field vs displacement curves of an actuator in a unipolar drive.

FIGURE 4 is a graph showing the frequency dependency of the displacement of an actuator in a unipolar drive; and

FIGURE 5 is a graph showing the electric field vs displacement characteristics of actuators using different electrode materials.

## SUMMARY OF THE INVENTION

According to the present invention, an actuator is composed of a monomorph-type piezoelectric ceramic.

Furthermore, in the actuator of the present invention, the monomorph-type piezoelectric ceramic is a $BaTiO_3$-based ceramic that has a dielectric loss of at least 5% at 1 kHz and whose dielectric loss at 100 kHz drops by at least 30% of the value at 1 kHz that in a single layer deflects without preliminary poling.

-3-

In a first embodiment the $BaTiO_3$-based ceramic contains 0.2 to 20 mol % of $SiO_2$ or 0.2 to 1.5 mol % $Al_2O_3$ or, if both $SiO_2$ and $Al_2O_3$ are present a total amount of 0.2 to 20 mol % and a molar ratio of $Al_2O_3$ to $SiO_2$ no higher than 0.8. The ceramic may also contain at least one oxide of an 5A-group element, Ga, Bi, Sb, W or a rare-earth element.

In another embodiment a semiconducting $BaTiO_3$-based ceramic with an oxidized surface is described which, prior to oxidizing, preferably has a specific resistivity in the range of 10 to $10^6 \Omega.cm$. The ceramic is composed entirely of $BaTiO_3$ or it may contain from 0.33 to 2 mol % of at least one oxide of a 5A-group element, Ga, Bi, Sb, W or a rare-earth element.

## DETAILED DESCRIPTION OF THE INVENTION

Two specific examples of the monomorph-type piezoelectric ceramic material of which the actuator of the present invention is made are described below.

-4-

## I. Dielectric-Loss Type BaTiO3-Based Ceramics

Commercial $BaTiO_3$-based ceramics which have high dielectric constants and small dielectric losses are currently used as capacitors. This kind of ceramics are not suitable for use as actuators since they do not possess good electric field vs displacement characteristics.

Surprisingly, the present inventors have found a group of $BaTiO_3$-based ceramics that have dielectric losses of no less than 5% at 1 kHz, and whose dielectric loss at 100 kHz drops by at least 30% of the value at 1 kHz, are of the monomorph type.

For instance, $BaTiO_3$-based ceramics having these characteristics can be prepared by doping $BaTiO_3$ with a specified amount of $SiO_2$ and/or $Al_2O_3$, and optionally with at least one oxide of an element selected from among a 5A-group element, Ga, Bi, Sb, W and a rare-earth element for the purpose of supressing the growth of grains in the ceramic. Examples of $BaTio_3$-based ceramics that are prepared in this manner include those which contain, in addition to $BaTiO_3$, 0.2 - 20 mol% of $SiO_2$, 0.2 - 1.5 mol% of $Al_2O_3$,

when both $SiO_2$ and $Al_2O_3$ are present the total amount is 0.2 - 20 mol%, with the molar ratio of $Al_2O_3$ to $SiO_2$ being no more than 0.8, or 1 - 2 mol% of $SiO_2$ and/or $Al_2O_3$ in combination with about 0.33 - 2 mol% of an oxide of a 5A-group element, Ga, Bi, Sb, W or a rare-earth element.

## II.  Surface-Oxidized Type Semiconducting BaTiO$_3$-Based Ceramic

According to another observation of the present inventors, semiconductive BaTiO$_3$-based ceramics that are oxidized at their surface but which remain semiconductive in their interior are also of the monomorph type.  A suitable semiconductive BaTiO$_3$-based ceramic may be selected from    the known BaTiO$_3$-based ceramics having specific resistivities of $10\text{-}10^6 \Omega.cm$, and they may be made entirely of BaTiO$_3$ or they may contain approximately 0.33 - 2 mol% of at least one oxide of an element selected from among 5A-group elements, Ga, Bi, Sb, W and rare-earth elements.

BaTiO$_3$-based ceramics are prepared in the following manner: A BaTiO$_3$ powder suitable for use as the starting material for the preparation of

-6-

either type of the $BaTiO_3$-based ceramics described above may be prepared by either the solid-phase reaction methods, in which a mixture of $BaCO_3$ and $TiO_2$ powders is calcined and ground into particles, or by the "co-precipitation method", in which oxalic acid or some other appropriate precipitant is added to an aqueous solution of water-soluble salts, e.g., the nitrate and hydrochloride salts, or barium and titanium to form a precipitate which then is calcined and ground into particles.

The ceramic of which the actuator of the present invention is made may be prepared by the process that is commonly employed in the production of conventional ceramics. This process includes steps such as weighing the starting powders, mixing the weighed powders, drying the powder mixture, forming the dried powders into a predetermined shape and sintering. The starting powders may be mixed by any of the conventional methods that employ ball mills or vibration mills. The green body may be formed by any appropriate method, such as pressing with molds, molding with a rubber press, slip casting, injection molding or tape casting.

The ease with which the green body can be sintered will vary with the composition and their amounts but the $BaTiO_3$ and

-7-

$BaTiO_3$-based powders described above can be sintered by holding them at temperatures of 1,200 - 1,450°C for 1 - 15 hours. Air may be used as the sintering atmosphere if $BaTiO_3$-based ceramics characterized by their dielectric loss properties are to be produced. If surface-oxidized type ceramics made entirely of $BaTiO_3$ are to be produced, an inert atmosphere such as Ar and $N_2$ or a reducing atmosphere such as $H_2$ may advantageously be used. If surface-oxidized type $BaTiO_3$-based ceramics that contain oxides of 5A-group elements, Ga Bi, Sb, W or rare-earth elements are to be produced, sintering may be conducted either in air or in the non-oxidizing atmosphere described above.

In order to prepare surface-oxidized type $BaTiO_3$-based ceramics, sinters that preferably have specific resistivities within the range of $10-10^6\Omega$.cm are first made by the procedures described above and then heated in air at 700 - 1,200°C for a period of from 10 minutes to 2 hours to oxidize the surface.

As already mentioned, the actuator of the present invention is composed of the monomorph type which is capable of deflecting even if it is in the form of a single layer of non-poled $BaTiO_3$-based ceramic. Although we do not wish to

-8-

be bound by any particular theory or mode of operation, it is believed the reason why this monomorph actuator deflects may be explained as follows: when a semiconductor is joined to a metal that does not produce an Ohmic contact, a Schottky barrier (or a Mott barrier if an insulating layer is present between semiconductor and metal) is formed in the structure of an electronic energy band; if such a metal is attached to both sides of the semiconductor and a voltage is applied across the semiconductor, a current will flow in the opposite direction at the interface on the other side. According to semiconductor theory, the electric field in the ceramic is not uniform and is concentrated in the vicinity of the metal-ceramic interface at which the reverse current is flowing.

This explanation will apply not only to semiconductive ceramics but also to the case where an insulative layer is formed in the surface of a semiconductive ceramic. If this insulative layer contains electric charges, i.e., electrons or ions, that will move in an electric field, application of a voltage causes the charges to move around in the insulator so that a potential barrier is produced at the interface between electrode and ceramic on the side where the insulating layer is present As in

-9-

the first case, the resulting electric field is concentrated in the vicinity of that electrode-ceramic interface.

In this way, a nonuniform electric field develops and only the side of the ceramic plate where field concentration has occurred either expands or shrinks   as a result of piezoelectricity, and the ceramic plate will undergo deflection.

The invention will be further explained with reference to the following non-limiting examples.

Examples 1-23 and Comparative Examples 1-7

In both Example 1 and Comparative Example 1, in which no additive was used, a $BaTiO_3$ powder was shaped directly into a plate (about 48 mm long x ca. 18 mm wide x ca. 10 mm thick) at a pressure of 1.5 tons/cm$^2$. In Examples 2 - 23 and Comparative Examples 2 - 7, a $BaTiO_3$ powder and a predetermined oxides were weighed and mixed in ethanol for 24 hours in a ball mill; the mixed powders were dried and shaped into a plate of the same dimensions as specified above and at a pressure of 1.5 tons/cm$^2$. In Example 1, the plate was sintered in argon gas at a

-10-

predetermined temperature for a predetermined period. In the other examples and comparative examples, air was used as the sintering atmosphere. The sintered materials were cut through on a plane parallel to the top surface so as to make actuators each made of a ceramic plate having the dimensions of 40 mmL, 15mmW and 0.5 mmT. In Examples 1 - 9, the specific resistivities of the ceramic samples were measured. Additive amounts (when present), sintering conditions and electrical properties are given in the Tables that follow.

Electrodes were formed on opposite faces of each ceramic sample by first coating a silver paste, then firing it in air at 800°C for 1 hour. In Examples 1 to 9, the surfaces of each ceramic sample were oxidized to become completely insulating as verified by measurements of their resistance. In Examples 10 to 23 and Comparative Examples 1 to 7, the dielectric loss of each sample was measured at predetermined frequencies.

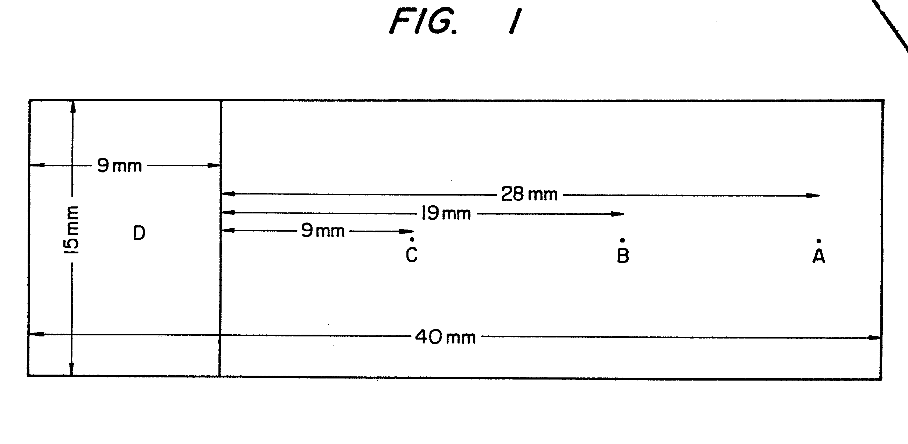

After electrodes had been attached in the manner described above, each of the actuators was placed in an electric field of 6 kV/cm, with one end being fixed over a distance of 9 mm from its edge (the fixed area being designated area D in Figure 1). The amounts of displacement of the actuator at three points that were 28 mm, 19 mm and 9 mm distance from the fixed area (designated by points A, B and C, respectively, in Figure 1) were measured with non-contact type sensor using an eddy current.

The results of the measurements conducted and the conditions employed in preparing the actuators are summarized in Tables 1 and 4.

When an ac voltage of 10 volts was applied to the actuators fixed in the manner described above, each of the actuators vibrated to produce sound waves having frequencies equal to those of the applied ac voltage.

## Example 24

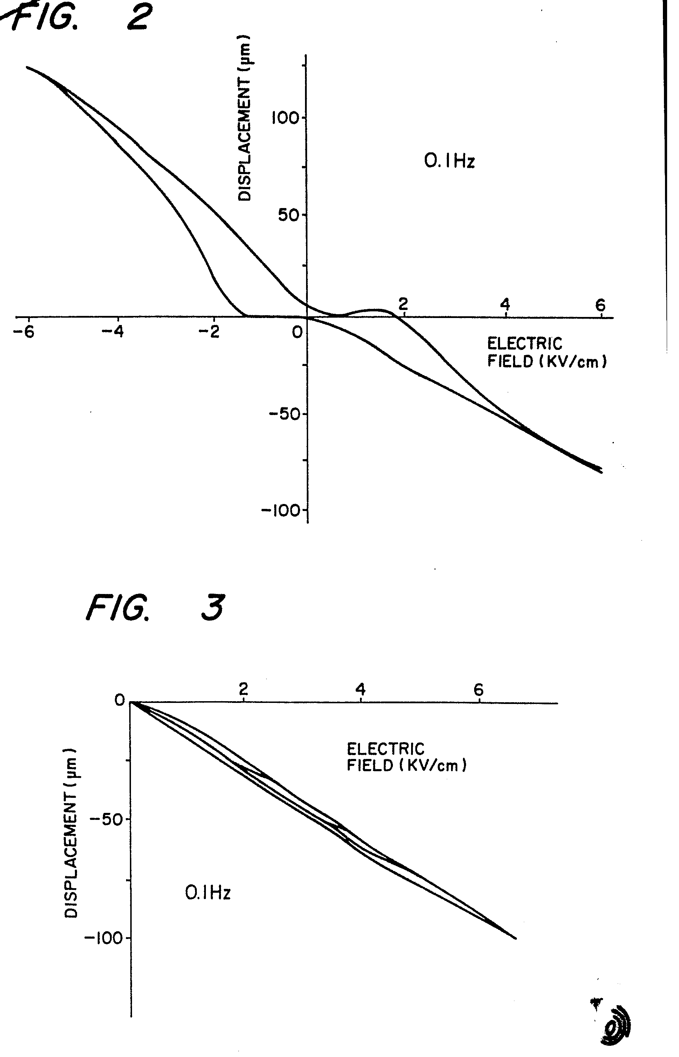

Ceramic actuator samples having the composition 93 mol% $BaTiO_3$, 5 mol% $SiO_2$ and 2 mol% $Al_2O_3$ were prepared as in Example 1 and fixed on a jig in the manner shown in Figure 1. The amount of displacement at point A of each sample was measured in either a bioplar or unipolar drive . Figure 2 is a graph showing the results of displacement measurement against electric field when the actuator was driven in a bipolar fashion by application of an ac voltage at a frequency of 0.1 Hz. In Figure

-12-

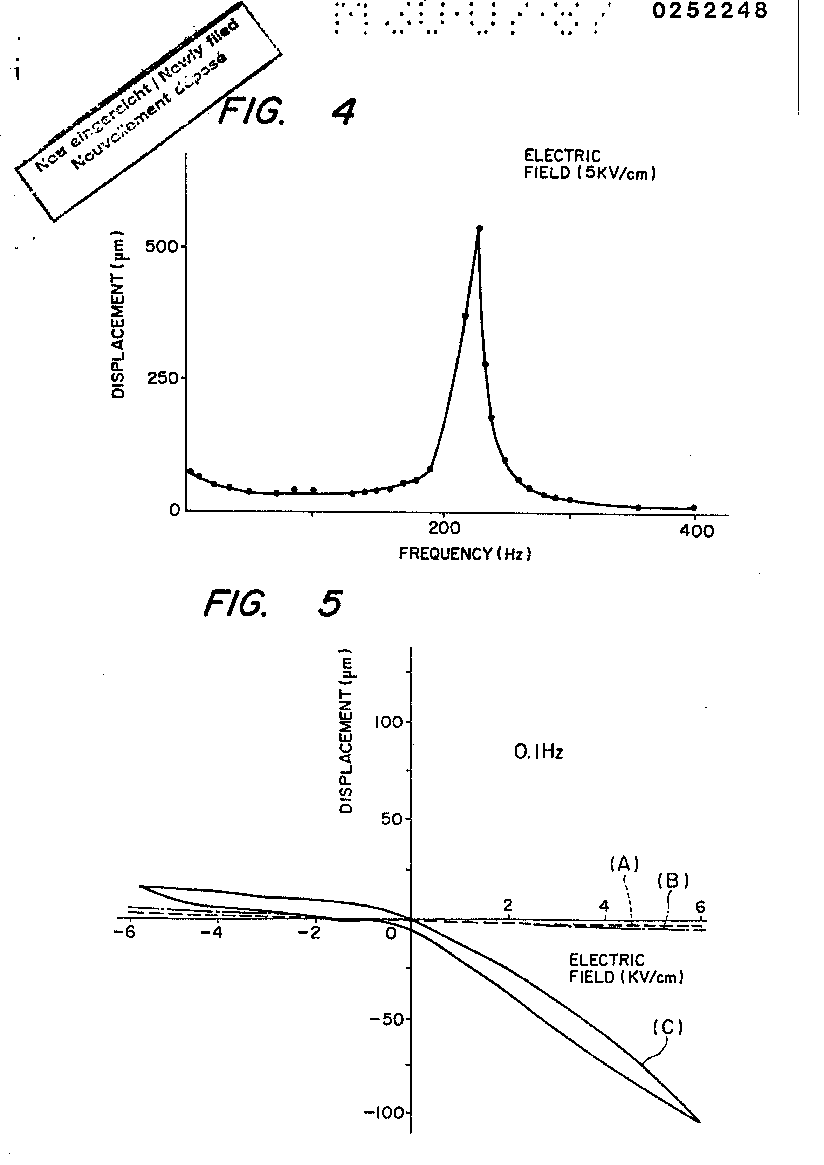

2, the displacement that occurred in the same direction as that of electric field is indicated by a plus sign. Figure 3 shows the field strength vs displacement characteristics of the actuator in a unipolar drive at a frequency of 0.1 Hz. The hysteresis measured from the electric field vs displacement characteristics was very small and the displacement changed substantially linearly with electric field (2.5, 3.8, 5 and 6.8 kV/cm). Figure 4 shows the relationship between frequency and displacement of the actuators in a unipolar drive at varying frequencies. At 220 Hz, each actuator experienced a maximum displacement which caused its mechanical resonance. Clearly, the relaxation time of charge transfer was not long enough to prevent the resonance of the actuators.

The effect of electrode type on the displacement of the actuator was evaluated by changing the electrode formed on both sides of the actuator. The results are shown in Figure 5, where line A refers to the actuator which was coated with a Ga-In layer on both sides, line B refers to the case where a gold film was vapor-deposited on both sides of the actuator, and line C refers to the case where one side of the actuator was provided with a fired Ag layer and the other side was coated with a

-13-

Ga-In layer.  It is apparent that the use of fired silver electrodes is important for producing appreciable amounts of displacement in the actuator.

TABLE 1

| Example No. | Additive | | Specific resistivity before oxidation ($\Omega$.cm) | Sintering | | Displacement ($\mu$m) | | |
| --- | --- | --- | --- | --- | --- | --- | --- | --- |
| | name | amount (mol%) | | temperature ($^\circ$C) | time (hr) | A | B | C |
| 1 | – | – | 200 | 1280 | 1 | 9 | 5 | 3 |
| 2 | $Nb_2O_5$ | 0.94 | 3000 | 1280 | 1 | 52 | 28 | 14 |
| 3 | $V_2O_5$ | 0.57 | 100 | 1320 | 1 | 56 | 30 | 12 |
| 4 | $Sb_2O_3$ | 0.48 | 60 | 1280 | 1 | 34 | 18 | 7 |
| 5 | $Bi_2O_3$ | 0.42 | 100 | 1280 | 1 | 38 | 19 | 7 |
| 6 | $WO_3$ | 0.32 | 3000 | 1280 | 1 | 24 | 13 | 10 |
| 7 | $Dy_2O_3$ | 0.18 | 9000 | 1240 | 1 | 18 | 8 | 4 |
| 8 | $Y_2O_3$ | 0.66 | 700 | 1360 | 1 | 27 | 12 | 6 |
| 9 | $Ga_2O_3$ | 1.25 | 10000 | 1320 | 1 | 11 | 5 | 3 |

TABLE 2

| | | Additive | | Dielectric Loss (%) | | | | Sintering | | Displacement | | |
|---|---|---|---|---|---|---|---|---|---|---|---|---|
| | | name | amount (mol%) | 1kHz | 10kHz | 100kHz | percentage drop | temp. (°C) | time (hr) | A | B | C |
| Example | 10 | $Al_2O_3$ | 0.2 | 7.8 | 7.7 | 4.3 | 44.9 | 1250 | 15 | 11 | 4 | 0 |
| | 11 | $SiO_2$ | 0.5 | 11.8 | 4.6 | 2.7 | 77.1 | 1250 | 15 | 48 | 21 | 5 |
| | 12 | $SiO_2$ | 1.5 | 7.4 | 3.6 | 2.4 | 67.6 | 1280 | 15 | 23 | 10 | 2 |
| Comparative Example | 1 | – | – | 4.4 | 4.8 | 7.1 | −61.4 | 1250 | 15 | 0 | 0 | 0 |
| | 2 | $Al_2O_3$ | 10.0 | 2.0 | 1.8 | 1.5 | 25.0 | 1250 | 15 | 0 | 0 | 0 |
| | 3 | $Al_2O_3$ | 2.0 | 4.1 | 2.5 | 3.2 | 22.0 | 1250 | 15 | 0 | 0 | 0 |
| | 4 | $SiO_2$ | 30.0 | 1.1 | 1.3 | 2.0 | −81.8 | 1250 | 15 | 0 | 0 | 0 |

0252248

TABLE 3

| | | Additive | | Dielectric Loss (%) | | | | Sintering | | Displacement (μm) | | |
|---|---|---|---|---|---|---|---|---|---|---|---|---|
| | | molar ratio of $Al_2O_3$ to $SiO_2$ | sum of $Al_2O_3$ and $SiO_2$ (mol%) | 1 kHz | 10 kHz | 100 kHz | percentage of drop | temp. (°C) | time (hr) | A | B | C |
| Example | 13 | 0.2 | 2 | 0.5 | 2.4 | 1.3 | 74.0 | 1250 | 15 | 4 | 2 | 0 |
| | 14 | 0.5 | 0.2 | 5.9 | 3.7 | 3.4 | 42.4 | 1250 | 15 | 14 | 6 | 1 |
| | 15 | 0.5 | 5 | 16.0 | 7.0 | 3.9 | 75.6 | 1250 | 15 | 33 | 15 | 3 |
| | 16 | 0.5 | 10 | 27.0 | 15.4 | 11.8 | 56.3 | 1250 | 15 | 58 | 27 | 6 |
| | 17 | 0.5 | 20 | 12.9 | 6.7 | 4.3 | 60.7 | 1250 | 15 | 27 | 12 | 3 |
| | 18 | 0.8 | 5 | 12.6 | 5.8 | 3.4 | 73.0 | 1250 | 15 | 9 | 4 | 1 |
| Comparative Example | 5 | 1.0 | 0.5 | 1.6 | 1.7 | 2.5 | −50.3 | 1250 | 15 | 0 | 0 | 0 |
| | 6 | 2.0 | 10 | 1.8 | 1.7 | 2.0 | −11.1 | 1250 | 15 | 0 | 0 | 0 |
| | 7 | 2.0 | 5 | 2.3 | 1.9 | 2.6 | −13.0 | 1250 | 15 | 0 | 0 | 0 |

| Example No. | Additive Al₂O₃ (mol%) | SiO₂ (mol%) | Another Additive name | amount | Dielectric Loss(%) 1 kHz | 10 kHz | 100 kHz | Percentage of drop | Sintering temp. (°C) | time (hr) | Displacement (μm) A | B | C |
|---|---|---|---|---|---|---|---|---|---|---|---|---|---|
| 19 | - | 2 | $Nb_2O_5$ | 0.56 | 49.3 | 25.3 | 11.2 | 77.3 | 1250 | 1 | 37 | 17 | 4 |
| 20 | 1 | 2 | $Nb_2O_5$ | 0.53 | 37.4 | 19.5 | 18.8 | 49.7 | 1280 | 1 | 30 | 14 | 3 |
| 21 | - | 2 | $V_2O_5$ | 1.02 | 75.7 | 46.3 | 22.2 | 70.7 | 1250 | 1 | 19 | 9 | 2 |
| 22 | 1 | 1 | $La_2O_3$ | 0.41 | 148.2 | 53.8 | 19.8 | 86.6 | 1440 | 1 | 12 | 6 | 1 |
| 23 | - | 2 | $Dy_2O_3$ | 0.33 | 11.2 | 5.8 | 7.7 | 31.3 | 1250 | 1 | 24 | 11 | 2 |

*Note: The "percentage of drop" in the column of "dielectric loss" in Tables 2, 3 and 4 indictaes the amount by which the dielectric loss of an actuator at 100 kHz decreased from the value at 1 kHz.

WE CLAIM:

1.  An actuator composed of a monomorph-type piezoelectric ceramic.

2.  The actuator according to claim 1 wherein said monomorph-type piezoelectric ceramic is a $BaTiO_3$-based ceramic that has a dielectric loss of at least 5% at 1 kHz and whose dielectric loss at 100 kHz drops by at least 30% of the value at 1 kHz.

3.  The actuator according to claim 2 wherein the $BaTiO_3$-based ceramic contains $SiO2'$ Al2O3 or their mixture as an additive.

4.  The actuator according to claim 3 wherein the $BaTiO_3$-based ceramic contains 0.2 to 20 mol% of $SiO_2$.

5.  The actuator according to claim 3 wherein the $BaTiO_3$-based ceramic contains 0.2 to 1.5 mol% $Al_2O_3$.

6.  The actuator according to claim 3 wherein the $BaTiO_3$-based ceramic contains both $SiO_2$ and $Al_2O_3$ in a total amount of 0.2 to 20 mol% in a molar ratio of $Al_2O_3$ to

$SiO_1$ and no higher than 0.8.

7. The actuator according to claim 3 wherein the $BaTiO_3$-based ceramic also contains at least one oxide of a 5A-group element, Ga, Bi, Sb, W or a rare-earth element.

8. The actuator according to claim 2 wherein the monomorph-type piezoelectric ceramic is a semiconductive $BaTiO_3$-based ceramic with an oxidized surface.

9. The actuator according to claim 8 wherein the semiconducting $BaTiO_3$-based ceramic has a specific resistivity, prior to oxidizing, in the range of 10 to $10^6 \Omega \cdot cm$.

10. The actuator according to claim 8 wherein the semiconductive $BaTiO_3$-based ceramic is composed entirely of $BaTiO_3$.

11. The actuator according to claim 8 wherein the semiconductive $BaTiO_3$-based ceramic contains from 0.33 to 2 mol% of at least one oxide of a 5A-group element, Ga, Bi, Sb, W or a rare-earth element.

FIG. 1

A

B

28 mm

19 mm

C

9 mm

40 mm

D

9 mm

15 mm

025224

## FIG. 2

0.1Hz

DISPLACEMENT (µm)

ELECTRIC
FIELD (KV/cm)

## FIG. 3

ELECTRIC
FIELD (KV/cm)

DISPLACEMENT (µm)

0.1Hz

## FIG. 4

ELECTRIC
FIELD (5KV/cm)

## FIG. 5